# EUROPÄISCHE PATENTANMELDUNG

(11) **EP 0 973 367 A2**
(43) Veröffentlichungstag der Anmeldung: **19.01.2000**
(21) Anmeldenummer: 99440167.7
(22) Anmeldetag: 25.06.1999
(51) Int. Cl.: H05K 7/20

(54) **Schrank für die Aufnahme vor Wärme erzeugenden elektrischen Einrichtungen**

(30) Priorität: 15.07.1998 DE 19831718
(71) Anmelder: ALCATEL, 75008 Paris (FR)
(72) Erfinder: Amberger, Reinhard, 70499 Stuttgart (DE)
(74) Vertreter: Brose, Gerhard, Dipl.-Ing.

(57) **Zusammenfassung**

Die Erfindung betrifft einen Schrank für die Aufnahme von Wärme erzeugenden elektrischen Einrichtungen.

Zur besseren Wärmeabfuhr ist der Kühlkörper (5) außerhalb des Schrankes (1) angeordnet.

## Beschreibung

Die Erfindung betrifft einen Schrank für die Aufnahme von Wärme erzeugenden elektrischen Einrichtungen, welcher eine metallische Rückwand besitzt und bei dem innerhalb des Schrankes wenigstens ein Baugruppenträger und hinter dem Baugruppenträger wenigstens ein Kühlköper angeordnet ist.

Ein solcher Schrank ist bekannt. Der bekannte Schrank, welcher zwischen Tür und Schrankrückwand an Holme geschraubte Baugruppenträger aufweist, ist mit Lüftungsschlitzen versehen. Bei häufig verwendeten Schränken mit unterschiedlicher Bestückung, welche Steckbaugruppen mit hoher Verlustleistung enthalten, ist die Wärmeableitung nicht ausreichend und deshalb der Einbau zusätzlicher Lüfter und/oder Wärmetauscher erforderlich.

Das der Erfindung zugrunde liegende technische Problem besteht darin, einen Schrank für die Aufnahme von Wärme erzeugenden elektrischen Einrichtungen zu schaffen, bei dem die Wärmeableitung verbessert ist.

Dieses technische Problem ist erfindungsgemäß dadurch gelöst, daß der Kühlköper außerhalb des Schrankes angeordnet und zusammen mit einer Trägerplatte für die Baugruppenträger an der Schrankrückwand befestigt ist. Eine vorteilhafte Einzelheit der Erfindung ist im Anspruch 2 enthalten.

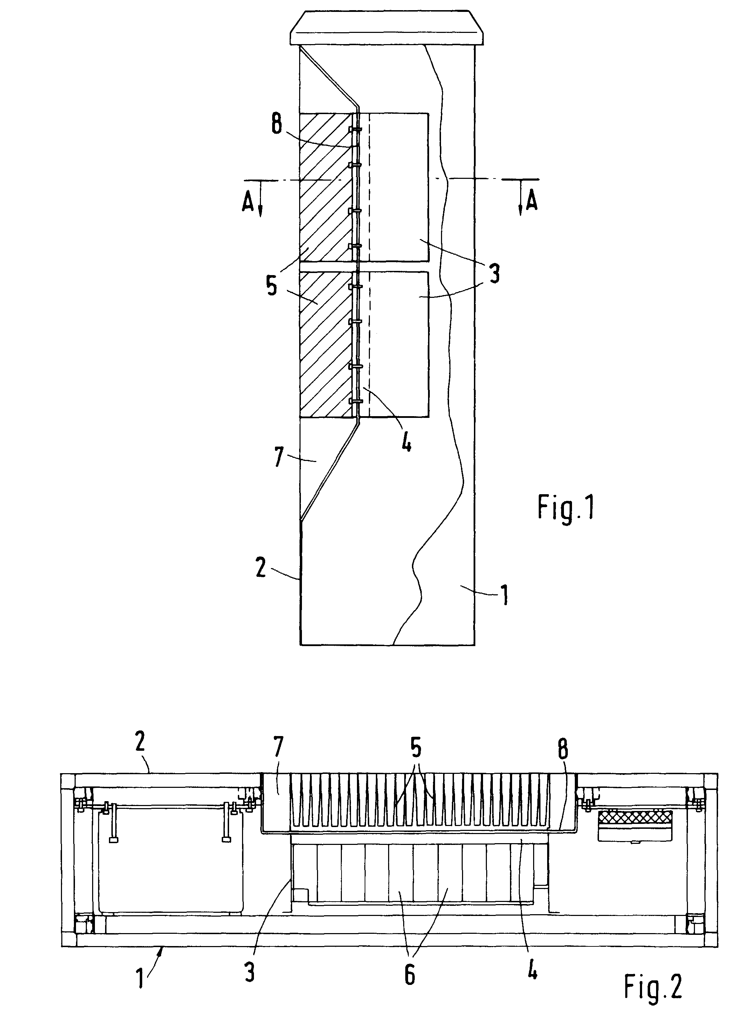

Die Erfindung ist nachstehend anhand der Figuren 1 und 2 näher erläutert.

Es zeigen:
- Fig. 1: eine Seitenansicht des erfindungsgemäßen Schrankes, teilweise geschnitten, und
- Fig. 2: den Querschnitt des Schrankes entlang der Linie AA in Fig. 1.

Wie aus Fig. 1 zu erkennen ist, sind im Schrank 1 auf einer Trägerplatte 4 die Baugruppenträger 3 angeordnet. Die Schrankrückwand besitzt eine wannenartige Vertiefung 7 mit einem ebenen Boden 8. In der wannenartigen Vertiefung 7 sind die Kühlkörper 5 angeordnet, welche an der Rückwand 2 bzw. der Trägerplatte 4 angeschraubt sind.

Fig. 2, in welcher die gleichen Teile mit den gleichen Bezugszeichen wie in Fig. 1 versehen sind, verdeutlicht, daß die Baugruppenträger 3 eine Mehrzahl von Steckeinschüben 6 aufweisen und die Anordnung des Kühlkörpers 5 in der wannenartigen Vertiefung 7.

## Patentansprüche

1. Schrank für die Aufnahme von Wärme erzeugenden elektrischen Einrichtungen, welcher eine metallische Rückwand besitzt und bei dem innerhalb des Schrankes wenigstens ein Baugruppenträger und hinter dem Baugruppenträger wenigstens ein Kühlkörper angeordnet ist, dadurch gekennzeichnet, daß der Kühlkörper (5) außerhalb des Schrankes (1) angeordnet und zusammen mit einer Trägerplatte (4) für die Baugruppenträger (3) an der Schrankrückwand (2) befestigt ist.

2. Schrank nach Anspruch 1,
dadurch gekennzeichnet, daß die Schrankrückwand (2) im Bereich der Baugruppenträger (3) eine nach innen gerichtete wannenartige Vertiefung (7) mit ebenem Boden (8) aufweist, in welcher der Kühlkörper (5) angeordnet ist.
